(19) **Europäisches Patentamt**

**European Patent Office**

**Office européen des brevets**

(11) **EP 1 119 860 B1**

(12) **EUROPÄISCHE PATENTSCHRIFT**

(45) Veröffentlichungstag und Bekanntmachung des Hinweises auf die Patenterteilung:
**18.12.2002 Patentblatt 2002/51**

(51) Int Cl.⁷: $G11C\ 11/16$

(21) Anmeldenummer: **99969820.2**

(86) Internationale Anmeldenummer:
**PCT/DE99/03135**

(22) Anmeldetag: **29.09.1999**

(87) Internationale Veröffentlichungsnummer:
**WO 00/019441 (06.04.2000 Gazette 2000/14)**

(54) **MAGNETORESISTIVER SPEICHER MIT ERHÖHTER STÖRSICHERHEIT**

MAGNETORESISTIVE MEMORY HAVING IMPROVED INTERFERENCE IMMUNITY

MEMOIRE MAGNETORESISTIVE A FIABILITE ACCRUE

(84) Benannte Vertragsstaaten:
**DE FR GB IE IT**

(30) Priorität: **30.09.1998 DE 19845069**

(43) Veröffentlichungstag der Anmeldung:
**01.08.2001 Patentblatt 2001/31**

(73) Patentinhaber: **Infineon Technologies AG**
**81669 München (DE)**

(72) Erfinder:
• **WEBER, Werner**
**D-80637 München (DE)**
• **THEWES, Roland**
**D-82194 Gröbenzell (DE)**

• **PLASA, Gunther**
**D-82031 Grünwald (DE)**

(74) Vertreter: **Fischer, Volker, Dipl.-Ing. et al**
**Epping Hermann & Fischer**
**Ridlerstrasse 55**
**80339 München (DE)**

(56) Entgegenhaltungen:
**EP-A- 0 773 551      DE-A- 19 744 095**
**US-A- 5 375 082      US-A- 5 699 293**
**US-A- 5 920 500**

• **PATENT ABSTRACTS OF JAPAN vol. 1997, no. 07, 31. Juli 1997 (1997-07-31) & JP 09 073773 A (SEIKO EPSON CORP), 18. März 1997 (1997-03-18)**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung betrifft einen magnetoresistiven Schreib-Lese-Speicher (MRAM), dessen Speichereffekt im magnetisch veränderbaren elektrischen Widerstand der Speicherzelle liegt.

Aus der internationalen Anmeldung WO 95/10112 sowie aus der US 5 699 293 sind ein nichtflüchtiger ferromagnetischer Schreib-/Lesespeicher bekannt, bei dem eine nichtmagnetische nichtleitende Schicht zwischen zwei ferromagnetischen Schichten vorhanden ist, wobei eine Schicht eine feste Orientierung und die andere Schicht eine durch den Betrieb festgelegte magnetische Orientierung aufweist und wobei der Widerstand über die beiden ferromagnetischen Schichten mit der Ausrichtung der jeweiligen magnetischen Momente variiert.

Die der Erfindung zugrundeliegende Aufgabe besteht darin, einen magnetoresistiven Schreib-/Lesespeicher anzugeben, bei dem, bei möglichst geringer Chipfläche, eine Erhöhung der Störsicherheit ermöglicht wird.

Diese Aufgabe wird erfindungsgemäß durch die Merkmale des Patentanspruchs 1 gelöst. Die weiteren Ansprüche betreffen vorteilhafte Ausgestaltungen der Erfindung.

Nachfolgend wird ein Ausführungsbeispiel der Erfindung anhand der Zeichnungen näher erläutert. Dabei zeigen

Figur 1     eine Schnittdarstellung eines Ausschnittes von einem erfindungsgemäßen MRAM und

Figur 2     eine Schnittdarstellung eines in Figur 1 vorhandenen magnetoresistiven Schichtensystems.

Die Erfindung liegt im wesentlichen darin, daß für jede einzelne Speicherzelle eine lokale Referenzspeicherzelle vorhanden ist und sich vertikal zwischen diesen beiden Speicherzellen eine gemeinsame Wortleitung befindet, wodurch eine sehr flächensparende und besonders gute Störungskompensation ermöglicht wird.

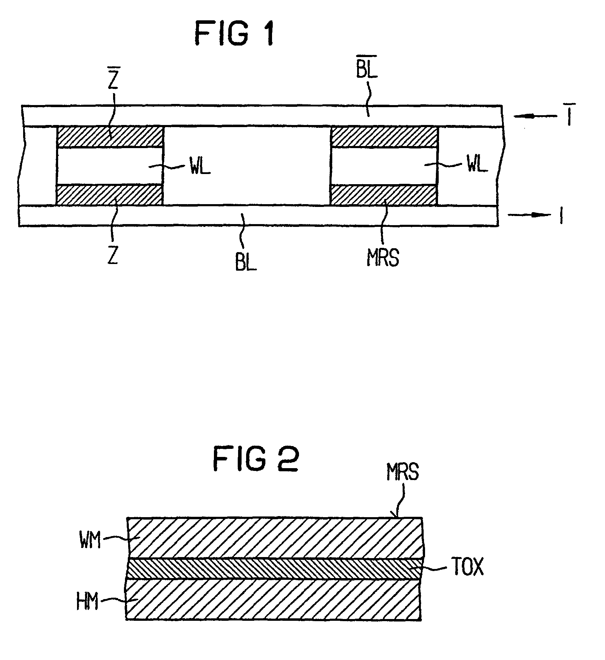

In Figur 1 ist ein Teil eines magnetoresistiven Speichers mit zwei Wortleitungen WL und zwei Bitleitungen BL, $\overline{BL}$ dargestellt. Zwischen der Bitleitung BL und den Wortleitungen WL liegen jeweils magnetoresistive Schichtensysteme MRS. In gleicher Weise liegen auch zwischen den Wortleitungen WL und der weiteren Bitleitung $\overline{BL}$ derartige magnetoresistive Schichtensysteme. Auf diese Weise ist eine Gesamtzellengröße von nur 4f$^2$ möglich, wobei f die kleinste auflösbare Strukturbreite bedeutet. Die Schichtsysteme zwischen der Bitleitung BL und der Wortleitung **WL** bilden reguläre Speicherzellen Z und die Schichtsysteme zwischen den Wortleitungen **WL** und der weiteren Bitleitung $\overline{BL}$ bilden komplementäre Speicherzellen $\overline{Z}$. In den komplementären Speicherzellen $\overline{Z}$ werden also die inversen Zustände zu den jeweils darunterliegenden Speicherzellen Z gespeichert bzw. mit Hilfe der Bitleitungen BL und $\overline{BL}$ eingeschrieben. Die Bitleitung $\overline{BL}$ führt das zum Signal auf der Bitleitung BL inverse Signal, wobei ein in der Bitleitung $\overline{BL}$ fließender Strom $\overline{I}$ in die entgegengesetzte Richtung fließt als ein Strom I in der Bitleitung BL. Da sich die Widerstände der magnetoresistiven Schichtsysteme abhängig von ihrem gespeicherten Zustand nur in der Größenordnung von ca. 10 Prozent unterscheiden, muß der Einfluß von Störgrößen berücksichtigt werden. Da die Signale auf den Bitleitungen BL und $\overline{BL}$ invers zueinander sind, kann durch Differenzbildung eine Verstärkung des Nutzsignales und eine Dämpfung der auf beide komplementären Zellen gleich einwirkenden Störgrößen und somit eine Erhöhung der Störsicherheit erreicht werden.

In Figur 2 ist das magnetoresistive Schichtensystem MRS der Zellen Z und $\overline{Z}$ von Figur 1 detailliert dargestellt. Das Schichtensystem MRS besteht im wesentlichen aus einer weichmagnetischen Schicht WM und einer hartmagnetischen Schicht HM, die beide durch ein Tunneloxid TOX voneinander getrennt sind. Die ferromagnetischen Schichten bestehen üblicherweise aus einem Material, das mindestens einen Stoff aus der Liste Eisen, Nickel und Kobalt enthält, wobei das Material der Schicht HM eine höhere Koerzitivfeldstärke aufweist als das Material der Schicht WM. Das Tunneloxid TOX besteht beispielsweise aus Al$_2$O$_3$. Anstelle des Tunneloxids TOX können auch andere dünne Isolatorschichten wie beispielsweise Siliziumnitrid oder ähnliches verwendet werden.

Das magnetoresistive Schichtensystem kann beispielsweise durch ausreichende Ströme in einer ausgewählten Bitleitung BL und einer ausgewählten Wortleitung WL die weichmagnetische Schicht WM einer Zelle Z in ihrer Magnetisierungsrichtung dauerhaft ändern und damit logische Zustände Null oder Eins einspeichern. Das Auslesen der Zelle Z wird dann dadurch bewirkt, daß durch die Zelle ein Strom von der zugehörigen Wortleitung zur zugehörigen Bitleitung fließt, wobei die Stromstärke von der Magnetisierungsrichtung der weichmagnetischen Schicht WM abhängt. Die Stromstärke ist unterscheidet sich z. B., wenn die Magnetisierungsrichtungen in den Schichten WM und HM parallel sind oder wenn sie antiparallel sind, weil die Tunnelwahrscheinlichkeiten in beiden Fällen unterschiedlich sind.

**Patentansprüche**

1. Magnetoresistiver Speicher,
   bei dem vertikal übereinander eine Schicht für eine erste Bitleitung (BL), ein magnetoresistives Schichtensystem (MRS) einer ersten Speicherzelle (Z), eine Schicht für Wortleitungen (WL), ein magnetoresistives Schichtensystem einer weiteren Speicher-

zelle ($\overline{Z}$) und eine Schicht für eine weitere Bitleitung ($\overline{BL}$) vorhanden sind, wobei die in den ersten und zweiten Speicherzellen (Z, $\overline{Z}$) speicherbaren Zustände jeweils invers zueinander sind.

2. Magnetoresistiver Speicher nach Anspruch 1, bei dem die weitere Speicherzelle im beschriebenen Zustand immer den inversen Zustand der darunterliegenden Zelle (Z) aufweist und bei der ein Strom (I) in der Bitleitung (BL) die entgegengesetzte Richtung aufweist als ein Strom ($\overline{I}$) in der darüberliegenden weiteren Bitleitung ($\overline{BL}$).

3. Magnetoresistiver Speicher nach einem der vorhergehenden Ansprüche, bei dem das magnetoresistive Schichtensystem (MRS) eine weichmagnetische Schicht (WM) und eine hartmagnetische Schicht (HM) aufweist, die durch ein dünnes Tunneloxid (TOX) voneinander getrennt sind.

**Claims**

1. Magnetoresistive memory, in which a layer for a first bit line (BL), a magnetoresistive layer system (MRS) of a first memory cell (Z), a layer for word lines (WL), a magnetoresistive layer system of a further memory cell ($\overline{Z}$) and a layer for a further bit line ($\overline{BL}$) are present vertically one above the other, the states which can be stored in the first and second memory cells (Z, $\overline{Z}$) in each case being inverse with respect to one another.

2. Magnetoresistive memory according to Claim 1, in which the further memory cell, in the written state, always has the inverse state of the underlying cell (Z), and in which a current (I) in the bit line (BL) has the opposite direction to a current ($\overline{I}$) in the overlying further bit line ($\overline{BL}$).

3. Magnetoresistive memory according to one of the preceding claims, in which the magnetoresistive layer system (MRS) has a soft-magnetic layer (WM) and a hard-magnetic layer (HM), which are isolated from one another by a thin tunnel oxide (TOX).

**Revendications**

1. Mémoire magnétorésistante, dans laquelle il est prévu, en superposition verticale, une couche pour une première ligne (BL) de bits, un système (MRS) stratifié magnétorésistant, une première cellule (Z) de mémoire, une couche pour des lignes (WL) de mots, un système stratifié magnétorésistant d'une autre cellule ($\overline{Z}$) de mémoire et une couche pour une autre ligne ($\overline{BL}$) de bits, les états pouvant être mémorisés dans les première et deuxième cellules ($\overline{Z}$) de mémoire étant respectivement inverses l'un de l'autre.

2. Mémoire magnétorésistante suivant la revendication 1; dans laquelle l'autre cellule de mémoire a, dans l'état décrit, toujours l'état inverse de la cellule (Z) sous-jacente et dans laquelle un courant (I) passant dans la ligne (BL) de bits a le sens opposé à un courant ($\overline{I}$) passant dans l'autre ligne ($\overline{BL}$) de bits se trouvant au-dessus.

3. Mémoire magnétorésistante suivant l'une des revendications précédentes, dans laquelle le système (MRS) stratifié magnétorésistant a une couche (WM) à magnétisme doux et une couche (HM) à magnétisme dur qui sont séparées l'une de l'autre par un mince oxyde (TOX) de tunnel.

## FIG 1

## FIG 2